**Europäisches Patentamt**

**European Patent Office**

**Office européen des brevets**

(19)

(11) Veröffentlichungsnummer: **0 458 055 A2**

## EUROPÄISCHE PATENTANMELDUNG

(12)

(21) Anmeldenummer: 91105924.4

(22) Anmeldetag: 13.04.91

(51) Int. Cl.⁵: $H02M\ 7/5395$, $H03K\ 17/14$

(30) Priorität: 21.05.90 DE 4016286

(43) Veröffentlichungstag der Anmeldung:
27.11.91 Patentblatt 91/48

(84) Benannte Vertragsstaaten:
CH DE FR GB IT LI

(71) Anmelder: **ROBERT BOSCH GmbH**
**Postfach 10 60 50**
**W-7000 Stuttgart 10(DE)**

(72) Erfinder: **Cohrs, Reinhard, Dipl.-Ing.**
**Rossbacher Hof**
**W-6120 Erbach(DE)**

(54) **Verfahren zur Impulsbreitenmodulation für einen Umrichter.**

(57)
2.1 Bei der Verwendung bipolarer Leistungstransistoren ergeben sich, durch die von der Temperatur, dem Strom und der Spannung abhängige Speicherzeit der Leistungstransistoren, von den Ansteuerimpulsen abweichende Durchschaltzeiten, deren Auswirkungen vermieden werden sollen.

2.2 Mit Hilfe der Basis-Emitter-Spannung der Leistungstransistoren lassen sich Signalspannungen erzeugen, die eine Korrektur dieser Abweichungen ermöglichen und/oder durch eine Verzögerung des folgenden Einschaltimpulses die Durchschaltzeiten an die Ansteuerimpulsbreiten anpaßt.

2.3 Hierdurch wird eine reaktionsschnelle, korrekte Regelung des Umrichterstromes möglich, die z. B. bei der Erzeugung von Wechselströmen eine bessere angepaßte Kurvenform ermöglicht.

EP 0 458 055 A2

Rank Xerox (UK) Business Services

Die Erfindung betrifft ein Verfahren gemäß dem Oberbegriff des Patentanspruches 1.

Mit derartigen Verfahren lassen sich bei entsprechend hoher Frequenz der in der Impulsbreite modulierten Schaltsignale, Umrichterausgangströme entsprechend einem sich stark veränderbarem Sollwert mit hohem Wirkungsgrad erzeugen. Bedingt durch die Speicherzeit beim Ausschalten der Schalttransistoren ergeben sich hierbei am Umrichterausgang zeitlich längere Einschaltsignale. Dies führt zu Problemen, die bei der Ansteuerung bzw. Erzeugung der impulsbreitenmodulierten Schaltsignale berücksichtigt werden müssen. Besonders wichtig ist es, sicherzustellen, daß während der verlängerten Einschaltzeit kein Einschalten des Schalttransistors im anderen Brückenzweig erfolgt und hierdurch ein zu großer Kurzschlußstrom erzeugt wird. Um dies zu vermeiden ist es bekannt, z. B. gemäß der EP-PS 01 24 619 über Zeitglieder eine Verriegelung vorzusehen, die ein Einschalten des anderen Schalttransistors während einer vorgegebenen Zeit nach Beendigung jedes Einschaltimpulses sperrt. In der EP-PS 0 124 619 erfolgt diese Verriegelung über UND-Gatter durch eine Hysteresis-Schaltung mit Hilfe von RC-Gliedern. Da die Speicherzeit der Schalttransistoren von der Temperatur, der Spannung und dem Strom abhängig ist, und vor allem bei großen Lastströmen und hoher Chip-Temperatur überproportional zunimmt, müssen die beiden Schalttransistoren einer Halbbrücke mittels einer Totzeit gegeneinander verriegelt werden, die der maximal möglichen Speicherzeit zuzüglich einer Sicherheitszeit entspricht.

Ein weiteres Problem ergibt sich dadurch, daß die Einschaltdauer der Schalttransistoren nicht mit der Impulsbreite der Schaltsignale übereinstimmt, so daß eine Korrektur der Schaltsignale erfolgen muß, um korrekt dem Sollwert entsprechende Ausgangsgrößen erzielen zu können. Üblicherweise erfolgt dies innerhalb einer Regelstrecke mit linearen Reglern bzw. durch einen Soll-Istwertvergleich. Durch die nichtlineare Veränderung der Speicherzeit und dadurch, daß die Totzeit nur zeitweilig zum Tragen kommt, ist eine Korrektur mit herkömmlichen linearen Reglern nur unvollständig beherrschbar.

So kann sich vor allem bei rasch änderndem Sollwert und insbesondere bei wechselnder Last, mit Änderungen der Stromrichtung im Lastkreis, eine störend veränderte Kurvenform der Ausgangsspannung ergeben.

Es ist Aufgabe der Erfindung, mit einfachen Mitteln eine Korrektur der Speicherzeit zu ermöglichen, die eine ausreichend genaue, dem Sollwert entsprechende Kurvenform der Ausgangsspannung bewirkt. Gelöst wird diese Aufgabe durch ein Verfahren und/oder eine Schaltungsanordnung mit den in den Ansprüchen gekennzeichneten Merkmalen.

In Weiterbildung der Erfindung wird die Aufgabe gelöst, die Totzeit der Schalttransistoren der eigentlichen Schalt- und/oder Speicherzeit anzupassen, wie sie in dem gerade vorliegenden Betriebszustand entsteht. Hierzu wird aus der Basis-Emitter-Spannung der Schalttransistoren eine Schaltspannung erzeugt und mit dieser eine Verriegelung des anderen Schalttransistors des Brückenzweiges während der gerade vorliegenden Speicherzeit bewirkt.

Die Erfindung wird nachstehend an Hand der in den Zeichnungen dargestellten Ausführungsbeispielen näher erläutert.

Es zeigen

Fig. 1    ein Schaltungsprinzip zur Erzeugung einer Signalspannung, die der Ausgangsspannung des Brückenzweiges entspricht, mit einer gegenseitigen Verriegelung des anderen Brückenzweiges,

Fig. 2    ein Schaltungsprinzip zur Korrektur der Speicherzeit der Schalttransistoren, mit einer gegenseitigen Verriegelung des anderen Brückenzweiges,

Fig. 3    ein Schaltungsbeispiel mit den kombinierten Merkmalen von Fig. 1 und Fig. 2,

Fig. 4    den Verlauf von Spannungen und Strömen an Schaltungspunkten gemäß Fig. 1 bis 4 bei positivem Laststrom,

Fig. 5    den Verlauf von Spannungen und Strömen an Schaltungspunkten gemäß Fig. 1 bis 3 bei negativem Laststrom und

Fig. 6    den Verlauf von Spannungen und Strömen an Schaltungspunkten gemäß Fig. 1 bis 3 bei wechselndem Laststrom.

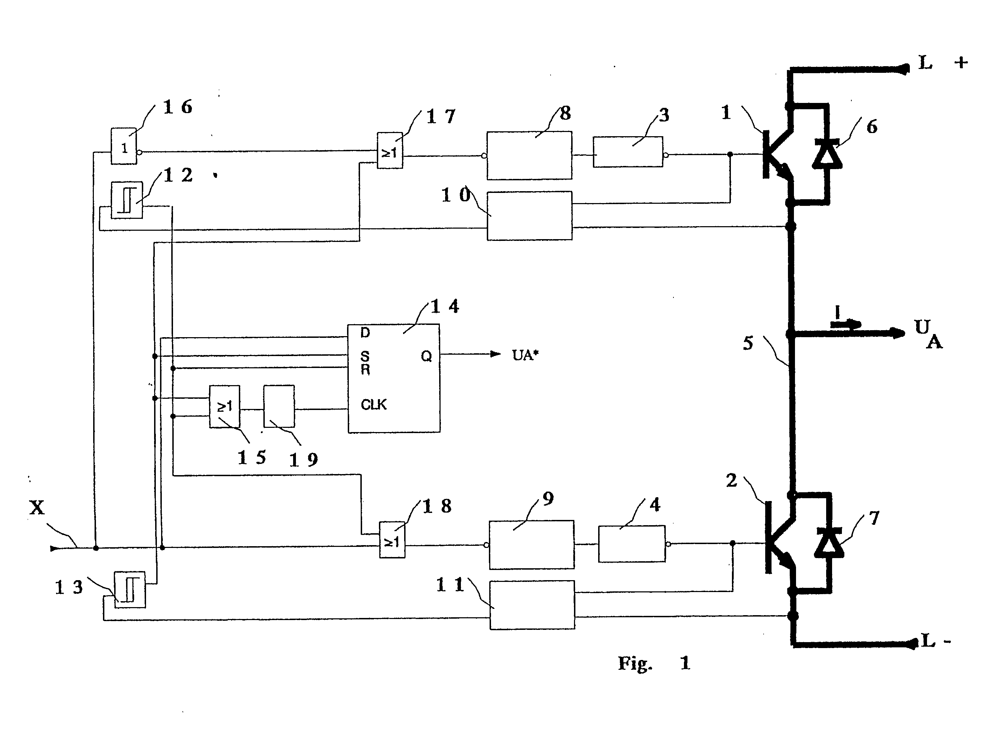

In Fig. 1 werden zwei Hochvolt-Leistungstransistoren 1 und 2 eines Brückenzweiges jeweils von Treiberstufen 3 und 4 in den gesperrten oder gesättigten Bereich geschaltet. Hierbei liegt der Kollektor des Leistungstransistors 1 am positiven Pol der Versorgungsspannung L+ des Leistungsteiles, der Emitter ist mit dem Kollektor des Leistungstransistors 2 des anderen Brückenzweiges verbunden, dessen Emitter mit dem negativen Pol L- der Versorgungsspannung verbunden ist. An der Emitter-Kollektor-Verbindung 5 zwischen den beiden Transistoren 1 und 2 liegt die Ausgangsspannung $U_A$, die an eine Last geführt ist. Antiparallel zu der Kollektor-Emitter-Strecke der Leistungstransistoren 1 und 2 liegt jeweils eine Freilaufdiode 6 und 7. Dieser in bekannter Weise geschaltete Brückenzweig kann Teil einer Brückenschaltung sein, die z. B. in dreifacher Ausfertigung am positiven und negativen Ausgang eines Gleichspannungszwischenkreises liegt und deren jeweilige Emitter-Kollektor-Verbindungen 5 an einem Wicklungsende einer Dreiphasenwicklung für einen Servomotor liegt.

Die Ansteuerung der Leistungstransistoren 1 und 2 über die Treiberstufen 3 und 4 sowie der Aufbau dieser Treiberstufen kann in gleicher Weise erfolgen wie dies in der DE-OS 35 22 429 näher dargestellt ist. Die Schaltsignale werden hierbei in gleicher Weise über Potentialtrennstufen 8 und 9 den Treiberstufen 3 und 4 zugeführt.

An beiden Leistungstransistoren 1 und 2 wird jeweils die Basis-Emitterspannung abgegriffen und jeweils über eine weitere Potentialtrennstufe 10 und 11 dem Eingang je eines Schritt-Triggers 12 und 13 zugeführt. Der Ausgang des Schritt-Triggers 12 für die Basis-Emitterspannung des an der positiven Versorgungsspannung L+ liegenden Leistungstransistors 1 ist an den R-Eingang eines D-Flip-Flops 14 und an den ersten Eingang eines ODER-Gatters 15 geführt. An den D-Eingang des D-Flip-Flops 14 ist das impulsbreitenmodulierte Stellsignal X gelegt, das über einen Negator 16 und ein weiteres ODER-Gatter 17 dem negierten Eingang der Potentialtrennstufe 8 zugeführt ist und weiterhin über ein weiteres ODER-Gatter 18 mit dem Eingang der Potentialtrennstufe 9 verbunden ist.

Das Stellsignal X kann in bekannter Weise in einem Mikroprozessor und/oder Zählstufen oder durch Spannungsvergleich mit einer Dreieckspannung erzeugt sein. Nimmt es einen High-Pegel ein, wird über den Negator 16 an den Eingang der Potentialtrennstufe 8 ein Low-Pegel angelegt, der z. B. über eine Leuchtdiode eines Optokopplers die mit ihrem anderen Ende am positiven Pol einer Versorgungsspannung liegt (nicht dargestellt) ein Signal auf den Eingang der Treiberstufe 3 gegeben, daß den Leistungstransistor 1 in den Sättigungsbereich steuert. Hierbei nimmt (wie die in der DE-OS 35 22 429 näher erläutert ist) die Basis des Leistungstransistors eine gegenüber dem Emitter positive Spannung an, die über die Potentialtrennstufe 10 den Ausgang des Schmitt-Triggers 12 auf einen High-Pegel setzt.

Schaltet das Stellsignal X auf einen Low-Pegel um, gelangt über den Negator 16 ein High-Pegel an den Eingang der Potentialtrennstufe 8, wodurch über die Treiberstufe 3 der Leistungstransistor 1 geöffnet bzw. in einen hochohmigen Zustand geschaltet wird. Das Schalten in diesen Zustand erfolgt jedoch nicht unmittelbar, sondern in bekannter Weise erst nach Ablauf einer Speicherzeit, deren Zeitspanne von der Temperatur im Leistungstransistor, der an ihm anliegenden Spannungen und der durch ihn fließenden Ströme abhängt. Vor allem bei großen Strömen nimmt diese Speicherzeit überproportional zu. Solange ein Strom durch den Leistungstransistor 1 fließt, also auch während der Speicherzeit, entsteht an der Basis-Emitter-Strecke ein Spannungsabfall, der am Ausgang des Schmitt-Triggers 12 einen High-Pegel bestehen läßt. Hierdurch bleibt das am D-Eingang liegende Stellsignal bis nach Ablauf der Speicherzeit am Q-Ausgang des D-Flip-Flops erhalten. Die Zeit des an diesem Q-Ausgang anliegenden Ausgangssignales $UA^*$ entspricht daher weitgehend der Zeit der an der Last liegenden Ausgangsspannung $U_A$. Damit diese Übereinstimmung auch bei anderer Stromrichtung oder wechselnder Stromrichtung durch die Last gegeben ist, wird es, wie später noch erläutert, erforderlich, die Umschaltung des D-Flip-Flops 14 von einem Clock-Impuls abhängig zu machen, der durch die positiven Flanken der Ausgangssignale der beiden Schmitt-Trigger 12 und 13 bewirkt wird. Hierzu sind die Ausgangssignale aus den Schmitt-Triggern 12 und 13 auf das ODER-Gatter geführt, dessen Ausgang über eine Zeitstufe 19 am Clock-Eingang des D-Flip-Flops liegt. Die Zeitstufe verzögert hierbei das Signal nur unwesentlich, sorgt aber dafür, daß die Signale am R- und S-Eingang sicher anliegen, bevor ein Clock erzeugt wird.

In gleicher Weise kann bei einem Low-Pegel des Stellsignals X der Leistungstransistor 7 in die Sättigung gesteuert werden, vorausgesetzt es fließt kein Strom über die Freilaufdiode 7, was auch für den Leistungstransistor 1 gilt, wenn dort ein Strom über die Diode 6 fließt, wie später noch erläutert wird.

Die Ausgangsspannung $UA^*$ am D-Flip-Flop 14 kann nun dazu dienen, bei der Erstellung des Stellsignales, z. B. durch einen entsprechenden Eingriff in den Regelkreis, eine Korrektur durchzuführen, da diese der tatsächlichen Einschaltdauer der Leistungstransistoren 1 und/oder 2 entspricht.

Das Ausgangssignal der Schmitt-Trigger 12 und 13 ist weiterhin jeweils dem zweiten Eingang des ODER-Gatters 17 oder 18 des anderen Brückenzweiges zugeführt und sorgt dafür, daß am Ausgang des jeweiligen ODER-Gatters 17 oder 18 ein High-Pegel anliegt, solange ein Strom durch den Leistungstransistor 1 oder 2 des anderen Brückenzweiges fließt, wobei die tatsächliche Speicherzeit der Leistungstransistoren 1 und 2 mit erfaßt wird.

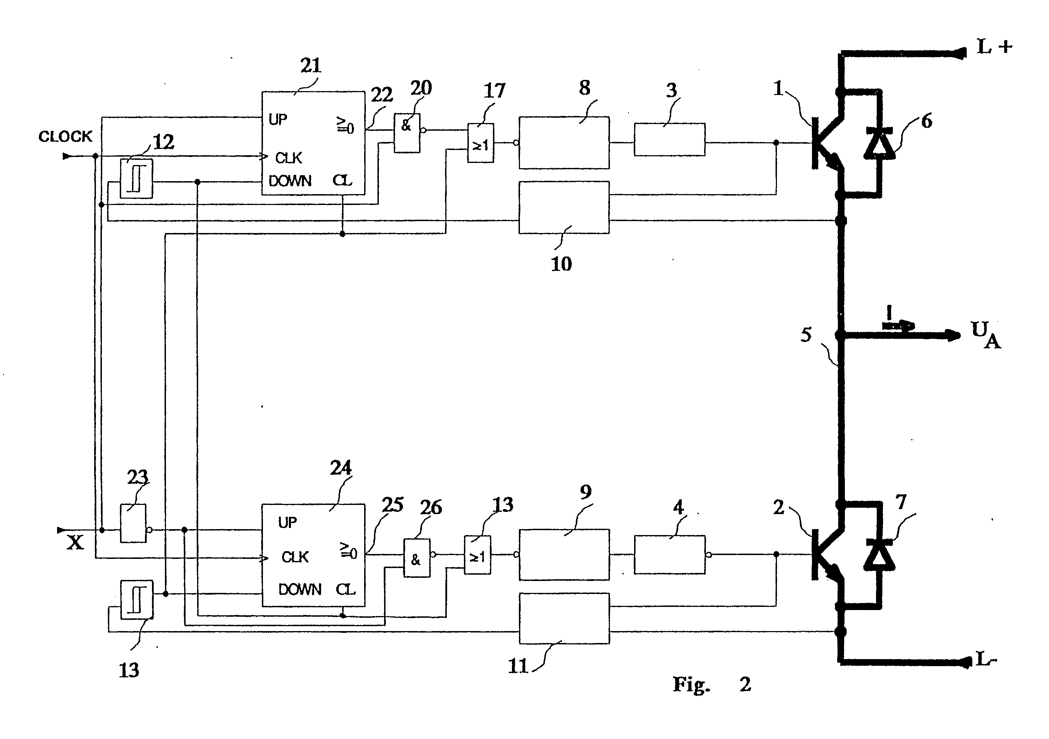

In Fig. 2 ist für eine in gleicher Weise geschaltete und angesteuerte Leistungsstufe (es werden die gleichen Kennziffern verwendet) eine Korrektur der Speicherzeit der Leistungstransistoren 1 und 2 vorgesehen. Dort erfolgt die Verriegelung des anderen Brückenzweiges in gleicher Weise über die Schmitt-Trigger 12 und 13 und die ODER-Gatter 17 und 18. Die Ansteuerung des ODER-Gatter 17 erfolgt hier jedoch anstelle des Negators 16 über ein NAND-Gatter 20, dessen zweiter Eingang am Ausgang eines Auf/Abwärtszählers 21 liegt. Den UP-Eingang dieses Auf/Abwärtszählers 21 ist das Stellsignal X zugeführt und der DOWN-Eingang mit dem Ausgang des Schmitt-Triggers 12 verbunden. Gezählt werden die einem Clock-Eingang CLK zugeführten Clock-Impulse einer höherfrequenten Impulsreihe, z. B. aus einem Mikroprozessor, wobei der Zähler durch ein Signal am Clear-Eingang CL auf Null gestellt werden kann. Dieser Clear-Eingang CL ist mit dem Ausgang des Schmitt-Triggers 13 des anderen Brückenzweiges verbunden.

Am Ausgang 22 des Auf/Abwärtszählers 21 liegt immer dann ein High-Pegel an, wenn der Zähler auf Null oder positive Werte enthält. Wird das Stellsignal X positiv, gelangt ein Schaltsignal bei einem Zählerstand Null über das NAND-Gatter 20 und das ODER-Gatter 17 zur Treiberstufe 3, die den Leistungstransistor 1 in den Sättigungsbereich schaltet. Bis ein entsprechendes Signal aus der Basis-Emitterspannung über den Schmitt-Trigger 12 auf den DOWN-Eingang des Auf/Abwärtszählers 21 gelangt, wird kurzfristig durchgezählt, wobei hierbei im wesentlichen die gegenüber der Ausschaltspeicherzeit erheblich kürzere Einschaltverzögerungszeit des Leistungstransistors 1 erfaßt wird. Durch das jetzt positive Ausgangssignal am Schmitt-Trigger 12 wird das Hochzählen gestoppt, bzw. es erfolgt ein Auf/Abwärtszählen mit den gleichen Clock-Impulsen, da nun auch der DOWN-Eingang aktiviert ist. Erst wenn das Stellsignal X wieder auf Null geht und über das NAND- und das ODER-Gatter die Treiberstufe den Leistungstransistor 1 hochohmig schaltet, erfolgt ein Abwärtszählen, solange bis über den Schmitt-Trigger 12 der DOWN-Eingang desaktiviert wird. Durch die wesentlich längere Speicherzeit des Leistungstransistors 1 wird hierbei der Auf/Abwärtszähler auf Werte unter Null gezählt, wobei der Ausgang 22 auf Low-Pegel fällt und das NAND-Gatter 20 sperrt. Da hierbei auch das Stellsignal X auf diesem Pegel liegt, hat dies vorerst keine Bedeutung für das Schalten des Leistungstransistors 1. Geht nun das Stellsignal wieder auf High-Pegel, bleibt das NAND-Gatter 20 solange gesperrt, bis durch den hierbei aktivierten UP-Eingang der Auf/Abwärtszähler auf Null heraufgezählt ist. Hierdurch erfolgt ein verzögertes Einschalten des Leistungstransistors 1, wobei die Einschaltdauer nun weitgehend der Dauer des Einschaltsignales des Stellsignales X entspricht.

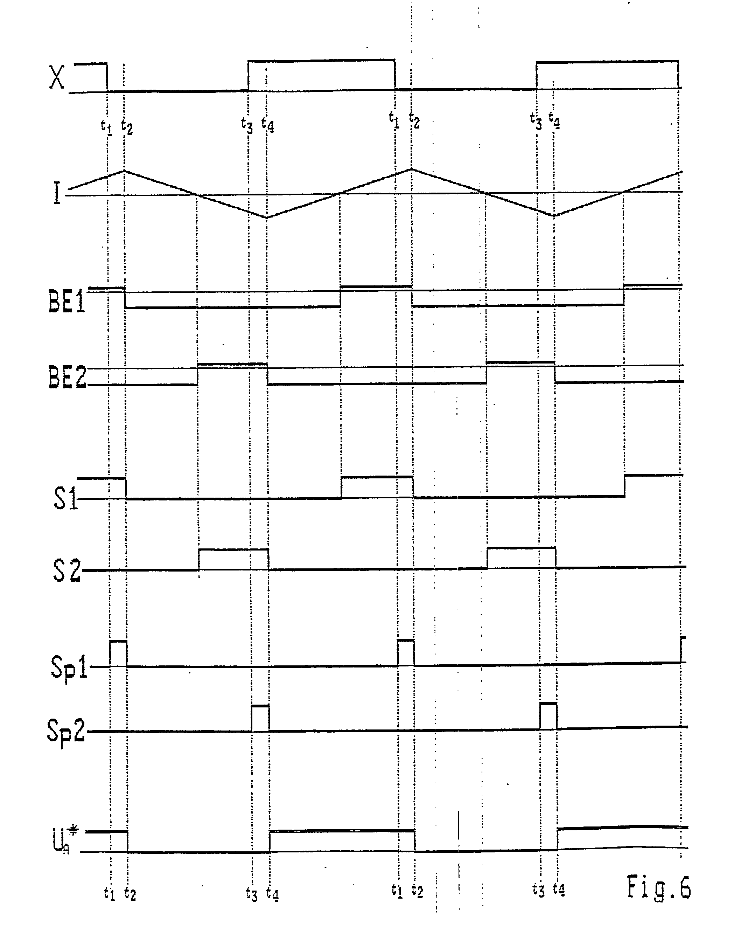

In gleicher Weise erfolgt die Ansteuerung des Leistungstransistors 2 mit dem Low-Pegel des Stellsignales X, das über einen Negator 23 am UP-Eingang eines weiteren Auf/ Abwärtszählers 24 liegt, dessen Clock-Eingang CLK die gleichen Clock-Signale zugeführt sind und an dessen DOWN-Eingang die Ausgangssignale des Schmitt-Triggers 13 liegen. Der Ausgang 25 des in gleicher Weise aufgebauten Auf/Abwärtszählers 24 gibt immer dann einen High-Pegel auf einen Eingang eines weiteren NAND-Gatters 26 ab, wenn der Zählerstand Null oder positiv ist. Die über den Negator 23 invertierten Stellsignale werden in gleicher Weise verzögert, wie die Ansteuersignale für den ersten Brückenzweig. Erfolgt bei wechselnder Stromrichtung durch die Last am Ausgang UA ein Durchschalten mit dem anderen Brückenzweig, wird mit dem Durchschalten des anderen Leistungstransistors der Auf/Abwärtszähler auf Null gesetzt. Dies geschieht durch eine Verbindung des Ausganges der Schmitt-Trigger 12 oder 13 mit jeweils einem Clear-Eingang CL des Auf/Abwärtszählers 21 oder 24 im anderen Brückenzweig. Hierdurch wird bei wechselndem Durchschalten der Leistungstransistoren 1 und 2 eine Verzögerung der Schaltsignale unterbunden. Warum dies erfolgt, wird bei der Beschreibung zu Fig. 6 näher erläutert.

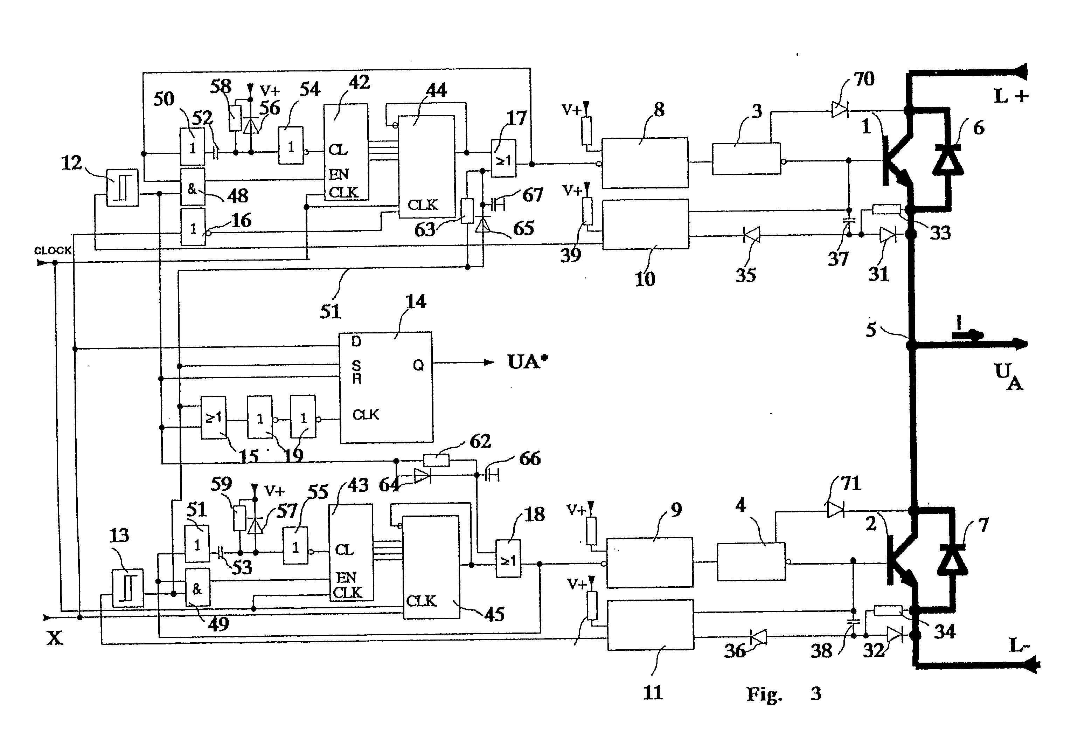

Zu Fig. 3 ist eine Schaltung angegeben, die beide Aufgaben gemäß Fig. 1 und Fig. 2 löst. So sind dort die Schaltelemente gemäß Fig. 1 (mit gleichen Kennziffern) in gleicher Weise miteinander verbunden, wobei das Zeitglied 19 vor dem Clock-Eingang des D-Flip-Flops 14 aus zwei hintereinanderliegenden Negatoren besteht. Die Trennstufen 8 bis 11 sind mit Optokopplern versehen, wobei an einem Leuchtdiodeneingang der Trennstufen 10 und 11, zur Erfassung der Basis-Emitterspannung, die Basis des jeweiligen Leistungstransistors 1 oder 2 liegt. Am Emitter der Leistungstransistoren 1 und 2 ist jeweils die Kathode einer Diode 31 und 32 angeschlossen, der jeweils ein Widerstand 33 und 34 parallelgeschaltet ist. Die Anode der Dioden 31 und 32 liegt jeweils an der Anode einer weiteren Diode 35 und 36, deren Kathode mit dem zweiten Leuchtdiodeneingang der jeweiligen Trennstufe 10 und 11 verbunden ist. Die Verbindung der beiden Dioden 31 mit 35 und 32 mit 36 ist über jeweils einen Kondensator 37 bzw. 38 mit der Basis des Leistungstransistors 1 bzw. 2 verbunden.

Hierbei handelt es sich um zusätzliche Sieb- und Trennglieder, die Störimpulse unterdrücken und zu hohe Ströme oder Spannungen vom Eingang der Trennstufe 10 oder 11 fernhalten. Der Widerstand 33 und 34 ist hierbei so bemessen, daß bei hochohmig geschaltetem Leistungstransistor 1 oder 2 mit einer negativen Basisspannung aus den Treiberstufen 3 oder 4 ein vorgegebener Strom über die jeweilige Leuchtdiode der Trennstufen 10 oder 11, der Diode 35 oder 36 und dem Widerstand 33 oder 34 fließt, der bewirkt, daß eine über je einen Widerstand 39 oder 40 am Ausgang der Trennstufe 10 oder 11 liegende positive Versorgungsspannung auf Null zusammenbricht. Steigt die Basisspannung der Leistungstransistoren 1 oder 2 auf Werte in Größe der Diodenspannung der Dioden 35 oder 36 an, sperrt diese Diode und am Ausgang der Trennstufe 10 oder 11 liegt dann eine Positive Ausgangsspannung. An der Basis anliegende positive Störspannungsspitzen werden über den Kondensator 37 oder 38 und die Diode 31 oder 32 abgeleitet. Durch die RC-Glieder 33, 37 und 34, 38 wirken sich kurze negative Störspitzen nicht aus, da diese erst den Kondensator 37 oder 38 umladen müssen.

Die Zählstufen 21 und 24 gemäß Fig. 2 sind hier durch je einen handelsüblichen Binärzähler 42 und 43 (z. B. einer integrierten Schaltung 4520) und je einem programmierbaren Rückwärts-Binärzähler 44 und 45 (z. B. einer integrierten Schaltung 4526) ersetzt, wobei während der Speicherzeit der entsprechenden Leistungstransistoren 1 oder 2 der jeweilige Binärzähler 42 oder 43 Clock-Impulse hochzählt, mit dieser Zahl den jeweiligen Binärzähler 44 oder 45 programmiert und das Durchschalten mit dem nächsten Schaltimpuls solange verzögert wird, bis der programmierte Wert wieder auf Null heruntergezählt ist. Zum Zählen ist jedem Clock-Eingang der vier Binärzähler 42 bis 45 ein Clock-Impulssignal gemäß Fig. 2 zugeführt. Ein Hochzählen der Binärzähler 42 oder 43 erfolgt immer nur dann, wenn am Ausgang eines UND-Gatters 48 oder 49 ein positives Signal anliegt, das an den Enable-Eingang des UND-Gatters 48 oder 49 verbunden ist, gleichfalls einen positiven Wert annimmt. Dies ist jedoch im wesentlichen nur während der Speicherzeit des entsprechenden Leistungstransistors 1 oder 2 der Fall.

Mit jeder negativen Einschaltimpulsflanke am Ausgang des ODER-Gatters 17 oder 18 wird über einen Verstärker 50 oder 51, einen Kondensator 52 oder 53 und einen Negator 54 oder 55 der Binärzähler 42 oder 43 über einen Clear-Eingang CL auf Null gesetzt. Am Eingang des Negators 54 und 55 liegt hierbei jeweils die Anode einer Diode 56, 57 und ein Widerstand 58, 59, die mit ihrem anderen Ende bzw. der Kathode am positiven Pol der Versorgungsspannung liegen. Hierdurch wird die positive Flanke der Schaltspannung unterdrückt. In der Verriegelungsleitung 60 und 61 zwischen dem Schmitt-Trigger 12 oder 13 und dem ODER-Gatter 18 oder 17 des anderen Brückenzweiges liegt jeweils eine Verzögerungsschaltung aus einem Widerstand 62 bzw. 63 mit parallel-geschalteter Diode 64 bzw. 65, die einen am Eingang des ODER-Gatters liegenden Kondensator 66 bzw. 67 auflädt. Durch diese Verzögerungsschaltung wird bewirkt, daß die vordere positive Impulsflanke unverzögert zum ODER-Gatter 17 bzw. 18 gelangt, die hintere negative Impulsflanke jedoch noch eine Zeitlang ein ausreichend positives Signal am Eingang des ODER-Gatters 17 bzw. 18 anliegen läßt. Hierdurch wird sichergestellt, daß der jeweilige Leistungstransistor 1 oder 2 solange gesperrt bleibt, bis der andere Leistungstransistor 2 oder 1 vollständig in den hochohmigen Bereich geschaltet ist.

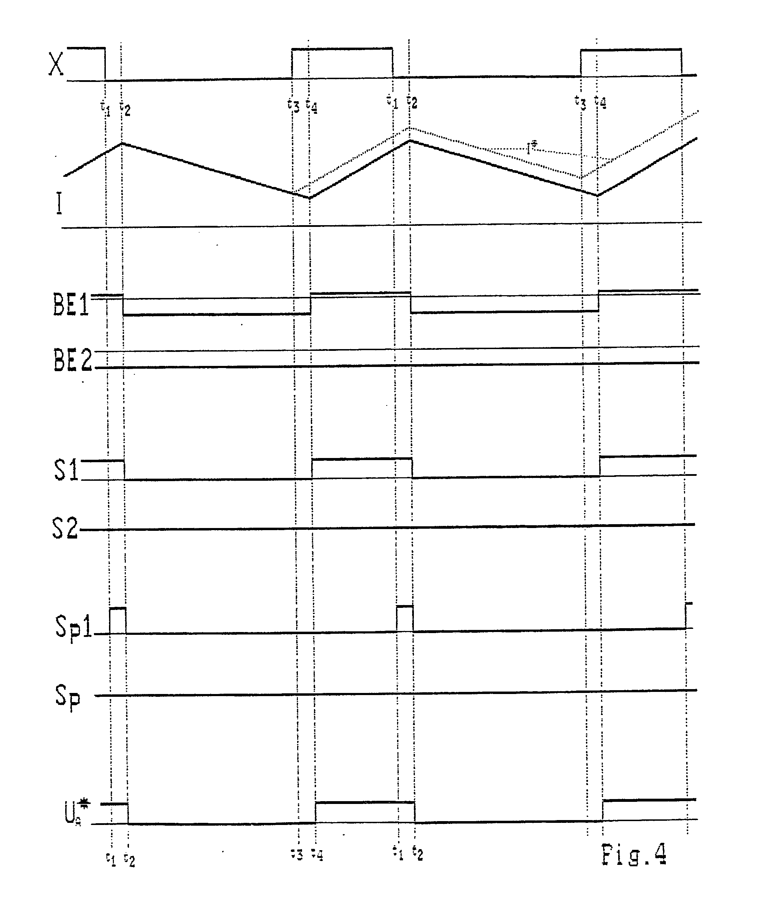

Die Leistungstransistoren 1 und 2 können aus mehreren in bekannter Weise zusammengeschalteten Leistungstransistoren bestehen, und die Last am Ausgang $U_A$ eine stark induktive Last sein, z. B. die Phasenwicklung eines Servomotores. In diesem Fall ergeben sich Spannungen und Ströme in den Schaltungen gemäß Fig. 1 bis 3, wie sie in Fig. 4 bis 6 bei unterschiedlichen Lastströmen auftreten.

In Fig. 4 ist das Stellsignal X und ein positiver Laststrom I dargestellt. An sich sollte mit positivem Stellsignal X über den in den Sättigungsbereich gesteuerten Leistungstransistor 1 der Laststrom I während der Zeit $t_3$ bis $t_1$ ansteigen. Durch die Speicherzeit dieses Leistungstransistors 1 bedingt erfolgt ein Umschalten in den hochohmigen Bereich erst zum Zeitpunkt $t_2$. Ohne eine Korrektur dieser Spei-cherzeit ($t_1$ bis $t_2$) würde sich ein Strom $I^*$ ausbilden, der ständig ansteigt. Gemäß der Erfindung mit Schaltungen gemäß Fig. 2 oder 3 wird die Basis-Emitterspannung $BE_1$ und $BE_2$ der beiden Leistungstransistoren 1 und 2 erfaßt und aus dieser eine hinter dem Schmitt-Trigger 12 und 13 anliegende Schaltspannung $S_1$ und $S_2$ gewonnen. Gemäß Fig. 2 wird in der Zählstufe 21 der zeitliche Unterschied zwischen der Dauer des positiven Stellsignals X ($t_3$ bis $t_1$) und dem Schaltsignal $S_1$ ($t_4$ bis $t_2$) erfaßt und der nächste Einschaltimpuls um diese Zeitdifferenz ($t_3$ bis $t_4$) verzögert. Mit dieser Verzögerung ergibt sich dann der Laststrom I.

Da die Einschaltverzögerung gegenüber der Speicherzeit bei den Leistungstransistoren üblicherweise keine wesentliche Rolle spielt (die Einschaltverzögerung beträgt z. B. 1 bis 2 usec. während die Speicherzeit 20 bis 30 usec. beträgt) und die Speicherzeit wesentlich stärker, insbesondere vom Laststrom I und der Halbleitertemperatur der Leistungstransistoren abhängt, kann eine Schaltung gemäß Fig. 3 gewählt werden. Dort wird am Ausgang der UND-Gatter 48, 49 eine Schaltspannung Sp1 und Sp2 erzeugt, die positive Impulse aufweist, die weitgehend nur während der Speicherzeit anliegen. Während dieser Impulsdauer wird der entsprechende Binärzähler 42 oder 43 hochgezählt und mit dem hochgezählten Wert der entsprechende programmierbare Binärzähler 44 oder 45 programmiert. Der nächste Einschaltimpuls wird danach erst dann an das ODER-Gatter 17 oder 18 weitergegeben, wenn der programmierte Wert über die Clock-Impulse wieder heruntergezählt ist.

Mit einem D-Flip-Flop 14 gemäß Fig. 1 und 3 kann weiterhin ein Ausgangsspannungssignal UA* aus den Schaltsignalen S1 und S2 erzeugt werden, das gemäß Fig. 1 zur Korrektur bei der Erzeugung des Stellsignales dienen kann oder gemäß Fig. 3 mit korrigierter Impulsdauer entsprechend Fig. 4 für eine zusätzliche Korrektur, z. B. der Kurvenform für einen sinusförmigen Summenausgangsstrom I im Regelkreis dienen.

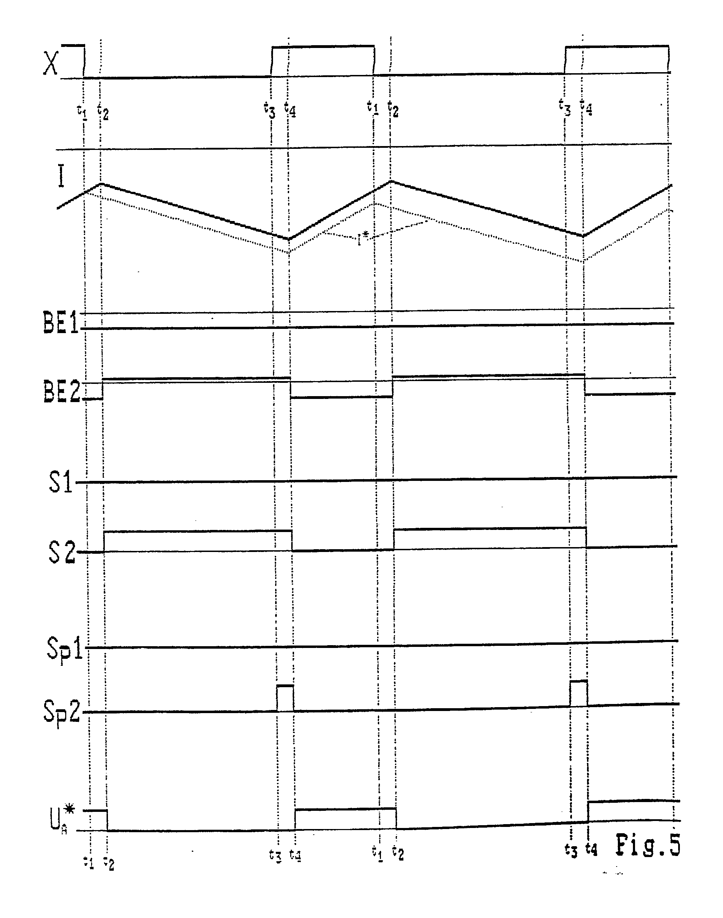

In Fig. 5 sind die gleichen Spannungen und Ströme für einen negativen Laststrom I dargestellt. Im Gegensatz zu Fig. 4 wird hier nur der Leistungstransistor 2 mit den Nullwerten des Stellsignales X durchgeschaltet. Dieses Durchschalten wird bei positivem Laststrom nicht möglich, da dort während dieser Zeit ($t_2$ bis $t_4$) ein Strom über die Freilaufdiode 7 parallel zum Leistungstransistor 2 fließt. Während dieses Freilaufdiodenstromes polt sich die Kollektor-Emitterspannung um, so daß schon hierdurch kein Durchschalten erfolgen kann. Das gleiche gilt für das Durchschalten des Leistungstransistors 1 bei einem negativen Laststrom I gemäß Fig. 5. Während der Speicherzeit ($t_1$ bis $t_2$) wäre dagegen ein solches Durchschalten möglich, wobei dann ein Kurzschluß von L+ zu L- über die beiden Leistungstransistoren erfolgen könnte. Dies wird jedoch in erster Linie durch das gegenseitige Verriegeln mit den ODER-Gattern 17 und 18 in Fig. 1 bis 3 unterbunden.

Fig. 6 zeigt die gleichen Spannungen und Ströme bei wechselndem Laststrom I. Zum Zeitpunkt $t_1$ geht das Stellsignal X auf Null und schaltet den Leistungstransistor 1 ab, wobei nach Ablauf der Speicherzeit ($t_1$ bis $t_2$) die Basis-Emitterspannung BE1 dieses Leistungstransistors 1 einen negativen Wert annimmt. Danach fließt solange ein Strom über die Freilaufdiode 7, bis der Strom I zu Null wird. Ab diesem Zeitpunkt kann der Leistungstransistor 2 durchschalten und die Basis-Emitterspannung BE2 wird positiv. Um zu verhindern, daß z. B. bei einem schleichendem Übergang des Laststromes I nur ein langsames Durchschalten der Leistungstransistoren 1 oder 2 erfolgt und sich dieser hierbei unnötig erwärmt, ist es bekannt, die Kollektorspannung z. B. über eine Diode 70 bzw. 71 zu überwachen und mit dieser die Treiberstufe 3 bzw. 4 derart zu sperren, daß ein Durchschalten erst dann erfolgt, wenn ein schnelles Durchschalten in den Sättigungsbereich möglich ist.

In gleicher Weise erfolgt ein Durchschalten des Leistungstransistors 1 erst dann, wenn der jetzt negative Laststrom I über die Freilaufdiode 6 auf Null zurückgegangen ist. Auch hier fließt ein Strom durch den Leistungstransistor 1 während der Speicherzeit ($t_1$ bis $t_2$) und durch den Leistungstransistor 2 während der Speicherzeit ($t_3$ bis $t_4$). Da jetzt jedoch die Stromrichtung während der aufeinanderfolgenden Speicherzeiten gegenläufig ist, wird eine Korrektur mit einem verzögerten Einschalten nicht mehr erforderlich, ja diese wäre von Nachteil, da jetzt ein Durchschalten erst mit dem Stromnulldurchgang erfolgt. Um hierbei eine Einschaltverzögerung zu unterbinden, wird in Fig. 2 jeweils mit einem Schaltsignal S1 oder S2 am Clear-Eingang CL des Auf/Abwärtszählers 21, 24 des anderen Brückenzweiges dieser auf Null gesetzt. So kann sich auch das Hochzählen, während der Zeit in der ein Durchschalten während des Freilaufdiodenstroms nicht möglich ist, nicht nachteilig auswirken. Die Speicherkapazität braucht hierbei nicht auf diese Zeit ausgelegt werden es genügt, wenn diese die maximal mögliche Einschaltschaltverzögerung bzw. Speicherzeit abdeckt. Da bei einer Schaltung gemäß Fig. 3 nur während der Dauer der Speicherzeitsignale Sp1 oder Sp2 am Ausgang des UND-Gatters 48 oder 49 hochgezählt wird und das Herauszählen aus dem programmierbaren Binärzähler 44 oder 45 zu Beginn des entsprechenden Impulses des Stellsignales X einsetzt, erfolgt dies in der Zeit, in der ein Durchschalten wegen des Freilaufdiodenstromes nicht möglich ist, so daß sich keine Auswirkung auf die Durchschaltzeiten der Leistungstransistoren ergibt.

Bei der Ausgangsspannung UA* des D-Flip-Flops wird die Speicherzeit der Leistungstransistoren jedoch mit erfaßt, wobei sich hier jedoch im wesentlichen nur eine Zeitverschiebung gegenüber dem Stellsignal X ergibt.

## Patentansprüche

1.  Verfahren zur Impulsbreitenmodulation für einen Umrichter mit zumindest zwei bipolaren Leistungstransistoren in Brückenschaltung und einer Einrichtung zur Ermittlung der Impulsbreite und Erzeugung der Schaltsignale entsprechend einem reaktionsschnell veränderbaren Sollwert, dadurch gekennzeichnet, daß die durch die Speicherzeit der Leistungstransistoren (1, 2) bewirkte, verlängerte Einschaltzeit erfaßt wird und mit der verlängerten Einschaltzeit eine Korrektur der Schaltzeiten der Schaltsignale (X) für die Leistungstransistoren erfolgt.

2.  Verfahren nach Anspruch 1, dadurch gekennzeichnet, daß durch Erfassen der Emitter-Basis-Spannung (BE1; BE2) der Leistungstransistoren (1, 2) die tatsächliche Einschaltzeit der Leistungstransistoren (1, 2) erfaßt wird und hieraus ein digitaler Ausgangsspannungsimpuls (S1, S2) erzeugt wird, der zur Korrektur der Schaltzeiten der Einrichtung zur Ermittlung und Erzeugung der Schaltsignale (X) und/oder der Regelelektronik zur Anpassung der Ansteuerung zugeführt wird.

3.  Verfahren nach einem der Ansprüche 1 oder 2, dadurch gekennzeichnet, daß der Umrichter ein Wechselspannungsumrichter ist und die Einrichtung zur Ermittlung und Erzeugung der Schaltsignale einen Mikroprozessor enthält, der entsprechend einem Sollwert Schaltsignale (X) erzeugt, die ein in der Kurvenform vorgegebenes Wechselspannungsausgangssignal am Umrichterausgang erzeugen.

4.  Verfahren nach einem der Ansprüche 1 bis 3, dadurch gekennzeichnet, daß das Schalten der Leistungstransistoren (1, 2) in beiden Brückenzweigen über ein impulsbreitenmoduliertes Stellsignal (X) auf zwei Schaltpegeln erfolgt, wobei der eine Schaltpegel ein Durchschalten des einen und der andere Schaltpegel ein Durchschalten des anderen Brückenzweiges je nach Stromrichtung durch eine induktive Last bewirkt.

5.  Verfahren nach einem der Ansprüche 1 bis 4, dadurch gekennzeichnet, daß ein der verlängerten Einschaltzeit entsprechendes digitales Schaltsignal (Sp1, Sp2) erzeugt wird und der Zeitwert dieses Schaltsignales dazu verwendet wird, das Einschaltsignal des nächsten Schaltimpulses entsprechend zu verkürzen.

6.  Verfahren nach einem der Ansprüche 2 bis 5, dadurch gekennzeichnet, daß in einer Zeitvergleichsstufe (21, 24) die zeitliche Länge des impulsbreitenmodulierten Schaltsignales (X) für die Leistungstransistoren (1, 2) mit der Länge des aus der Emitter-Basisspannung der Schalttransistoren gewonnenen digitalen Ausgangsspannungsimpulses (S1, S2) verglichen wird, ein entsprechender Wert für die zeitliche Differenz gespeichert wird und mit diesem Wert die Einschaltimpulsflanke des nächsten impulsbreitenmodulierten Schaltsignales (X) für die Leistungstransistoren (1, 2) verzögert wird.

7.  Verfahren nach einem der Ansprüche 1 bis 6, dadurch gekennzeichnet, daß ein die verlängerte Einschaltzeit enthaltendes digitales Signal (S1, S2) erzeugt wird, das zum Schutz gegen ein gleichzeitiges Durchschalten des anderen Leistungstransistors (2, 1) der Brückenschaltung eine Verriegelung der Ansteuerung dieses anderen Leistungstransistors (2, 1) bewirkt.

8.  Verfahren nach einem der Ansprüche 5 bis 7, dadurch gekennzeichnet, daß bei wechselnder Stromrichtung (I) durch die Last am Ausgang (UA) des Umrichters das Verkürzen des nächsten Schaltimpulses verhindert wird.

9.  Schaltungsanordnung für ein Verfahren nach einem der Ansprüche 2 bis 4, dadurch gekennzeichnet, daß die Basis-Emitterspannung (BE1, BE2) der beiden Leistungstransistoren (1, 2) jeweils über eine Potentialtrennstufe (10, 11) einem Schmitt-Trigger (12, 13) zugeführt ist, die digitale Ausgangsspannung (S1, S2) dieser Schmitt-Trigger Eingängen eines D-Flip-Flops (14) zugeführt sind, die ein Setzen oder Rücksetzen des D-Flip-Flops (14) bewirken, wenn die Basis-Emitterspannung (BE1, BE2) der beiden Leistungstransistoren (1, 2) über einen Minimalpegel steigt, dem D-Eingang dieses Flip-Flops (14) die Schaltsignale (X) für die Leistungstransistoren zugeführt sind und an einem Ausgang des Flip-Flops (14) ein digitales Ausgangssignal (UA*) abgegriffen ist, das während der tatsächlichen Einschaltdauer der Leistungstransistoren (1, 2) anliegt und dieses Ausgangssignal der Einrichtung zur Ermittlung und Erzeugung der Schaltsignale und/oder der Regelelektronik für die Impulsbreitenmodulation zugeführt ist.

10. Schaltungsanordnung für ein Verfahren nach einem der Ansprüche 2 bis 9, dadurch gekennzeichnet, daß Gatterstufen (48, 49) vorgesehen sind, an welche die Schaltspannung für die Leistungstransistoren (1, 2) und die digitale Ausgangsspannung (S1, S2) aus der Basis-Emitterspannung in einer Weise angelegt sind, daß an einem Ausgang der Gatterstufe (48, 49) während der Speicherzeit der Leistungstransistoren ein Speicherzeitimpuls (Sp1, Sp2) anliegt.

11. Schaltungsanordnung nach Anspruch 10, dadurch gekennzeichnet, daß der Speicherzeitimpuls (Sp1, Sp2) einem Eingang einer Zählstufe (42, 48) zugeführt ist, der Clockimpulse aus einer höherfrequenten Clockimpulsreihe zugeführt sind, die während der Dauer des Speicherzeitimpulses hochgezählt werden, die hochgezählten Clockimpulse mit Beginn des nächsten Schaltimpulses für die Leistungstransistoren (1, 2) heruntergezählt werden, und daß bei einem vorgesehenen Zählerstand eine Ausgangsspannung erzeugt wird, die ein verzögertes Einsetzen dieses nächsten Schaltimpulses bewirkt.

12. Schaltungsanordnung für ein Verfahren nach einem der Ansprüche 1 bis 11, dadurch gekennzeichnet, daß die Leistungstransistoren (1, 2) über Treiberstufen (3, 4) geschaltet werden, denen Zählstufen (21, 24) vorgeschaltet sind, den Zählstufen (21, 24) das impulsbreitenmodulierte Schaltsignal (X) für die Leistungstransistoren (1, 2) weiterhin die aus der Basis-Emitterspannung der Leistungstransistoren (1, 2) abgeleiteten, durch die Speicherzeit der Leistungstransistoren (1, 2) verlängerte Ausgangsspannungsimpulse (S1, S2) und zusätzliche Clock-Impulse einer höherfrequenten Clockimpulsreihe zugeführt sind, in den Zählstufen (21, 24) ein Vergleich von Zählimpulsen erfolgt, die während der Dauer des impulsbreitenmodulierten Schaltsignales (X) für die Leistungstransistoren (1, 2) gezählt werden, mit Zählimpulsen die während der Dauer des verlängerten Schaltsignals (S1, S2) gezählt werden, und daß die Differenzimpulszahl in den Zählstufen (21, 24) nach dem Ende des verlängerten Schaltsignals (S1, S2) gespeichert bleibt und der nächste Impuls des Schaltsignals (X) für die Leistungstransistoren (1, 2) erst dann an die Treiberstufen (3, 4) gelegt wird, wenn die Differenzimpulszahl auf Null heruntergezählt ist.

13. Schaltungsanordnung nach einem der Ansprüche 1 bis 12, dadurch gekennzeichnet, daß der digitale Ausgangsspannungsimpuls (S1, S2) aus der Basis-Emitterspannung der Leistungstransistoren (1, 2) einer Gatterstufe (17, 18) zur Erzeugung der Schaltimpulse für den Leistungstransistor des anderen Brückenzweiges zugeführt ist und diese Gatterstufe (17, 18) eine Verriegelung dieses Brückenzweiges bewirkt, solange der Ausgangsspannungsimpuls (S2, S1) des anderen Brückenzweiges anliegt.

14. Schaltungsanordnung nach einem der Ansprüche 1 bis 13, dadurch gekennzeichnet, daß es sich bei den Leistungstransistoren (1, 2) um Hochvolt-Leistungstransistoren handelt, die über Treiberstufen (3, 4) angesteuert werden, die Treiberansteuerung über Potentialtrennstufen (8, 9) insbesondere Optokoppler erfolgt und die Basis-Emitterspannung (BE1, BE2) der Leistungstransistoren über eine weitere Potentialtrennstufe einer digitalen Ansteuerschaltung für die Treiberansteuerung zugeführt ist.

15. Schaltungsanordnung nach einem der Ansprüche 1 bis 12, dadurch gekennzeichnet, daß die Brückenschaltung Teil eines Wechselspannungsumrichters ist, der die Phasenströme für eine Asynchronmaschine erzeugt, die als Servomotor in einen Vierquadrantenantrieb dient.

Fig. 1

EP 0 458 055 A2

Fig. 2

Fig. 3

Fig.4

Fig.5

EP 0 458 055 A2

Fig.6

14